# EUROPÄISCHE PATENTSCHRIFT

(11) **EP 3 417 244 B1**
(45) Veröffentlichungstag und Bekanntmachung des Hinweises auf die Patenterteilung: **09.09.2020**
(21) Anmeldenummer: 17705598.5
(22) Anmeldetag: 14.02.2017
(51) Int. Cl.: G01D 5/20, G01D 5/22, G01B 7/00, G01D 5/243, G01R 27/26

(54) **POSITIONSSENSOR**
SENSOR
CAPTEUR

(30) Priorität: 17.02.2016 DE 102016202403
(43) Veröffentlichungstag der Anmeldung: 26.12.2018
(73) Patentinhaber: Continental Teves AG & Co. OHG, 60488 Frankfurt am Main (DE)
(72) Erfinder: ACKER, Heinrich, 65824 Schwalbach (DE)
(86) Internationale Anmeldenummer: PCT/EP2017/053295
(87) Internationale Veröffentlichungsnummer: WO 2017/140678

(56) Entgegenhaltungen:
- EP-A2- 0 337 939
- WO-A1-2015/129229
- DE-A1- 4 311 973
- DE-A1- 19 812 965
- DE-A1-102005 007 731

## Beschreibung

Die Erfindung betrifft einen Sensor, welcher beispielsweise zum Erfassen von Messgrößen verwendet werden kann. Insbesondere kann ein solcher Sensor in Automobilen zum Erfassen der Stellung eines Pedals oder eines Reglers verwendet werden.

Bekannte Sensoren sind häufig komplex aufgebaut und schwer auszuwerten.

DE 10 2005 007731 A1 beschreibt einen Positionssensor, aufweisend einen Schaltungsträger mit Messinduktivitäten, die mit einer Referenzinduktivität gekoppelt sind.

Eine induktive Sensoranordnung ist auch aus EP 0 337 939 A2 bekannt, die das Ziel verfolgt, Abstandsfehler bei der Ermittlung der Relativlage der Anordnung zu einem Objekt zu kompensieren.

DE 43 11 973 A1 betrifft eine magneto-induktive Sensorzeile mit nebeneinander und / oder übereinander angeordneten Spulen.

DE 198 12 965 A1 beschreibt eine Vorrichtung zum induktiven Messen der Lage eines Metallbandes mittels einer Sekundärspule und einer mit Wechselspannung gespeisten Primärspule.

WO 2015/129229 A1 betrifft einen Positionssensor, bei dem mittels eines Prozessors die Wahrscheinlichkeit verringert werden soll, dass Zeiträume, in denen Erregungsspulen arbeiten, einander bei Aktivierung von Detektoren überlappen.

Es ist deshalb eine Aufgabe der Erfindung, einen Sensor bereitzustellen, welcher alternativ, beispielsweise konstruktiv einfacher oder einfacher zu beschalten ausgeführt ist.

Dies wird erfindungsgemäß durch einen Sensor nach Anspruch 1 erreicht. Vorteilhafte Ausgestaltungen können beispielsweise den Unteransprüchen entnommen werden. Der Inhalt der Ansprüche wird durch ausdrückliche Inbezugnahme zum Inhalt der Beschreibung gemacht.

Die Erfindung betrifft einen Sensor. Dieser weist einen Schaltungsträger auf. Er weist ferner eine Anzahl von Messinduktivitäten auf, welche auf dem Schaltungsträger aufgebracht sind. Außerdem weist er eine Referenzinduktivität auf, welche mit den Messinduktivitäten gekoppelt ist. Hierbei kann es sich insbesondere um eine magnetische, eine elektrische oder eine kombinierte elektrische und magnetische Kopplung handeln.

Mittels der Anordnung der Messinduktivitäten auf dem Schaltungsträger können eine besonders einfache Herstellung und ein einfacher Aufbau erreicht werden. Insbesondere kann die Referenzinduktivität ein Magnetfeld erzeugen, welches von den Messinduktivitäten erfasst wird, und welches von einer externen Größe und/oder von der Position oder der Lage eines Messkörpers abhängt. Hierauf wird weiter unten näher eingegangen werden. Vorteilhaft sind die Messinduktivitäten von der Referenzinduktivität elektrisch isoliert. Beispielsweise können sie durch einen Luftspalt getrennt sein. Sie können jedoch beispielsweise auch durch geeignete elektrisch isolierende Materialien getrennt sein. Dies vermeidet Kurzschlüsse und Fehlfunktionen.

Der Sensor kann insbesondere als linearer Positionssensor ausgebildet sein. Er kann auch als Kraftsensor ausgebildet sein. Derartige Anwendungen haben sich in der Praxis als vorteilhaft erwiesen.

Die Messinduktivitäten sind entlang eines Pfads auf dem Schaltungsträger aufgebracht. Insbesondere kann es sich dabei um einen geraden Pfad, einen linearen Pfad oder auch um einen Bogen oder Kreisbogen handeln. Derartige Anordnungen sind insbesondere dann vorteilhaft, wenn eine Größe entlang eines solchen Pfads gemessen werden soll, wobei sich beispielsweise ein Messkörper entlang eines solchen Pfads verschieben kann.

Gemäß einer bevorzugten Ausführung weist der Sensor ferner einen Messkörper auf, welcher relativ zum Schaltungsträger beweglich ist. Ein solcher Messkörper kann beispielsweise mit externen Einrichtungen gekoppelt sein, um eine zu messende Größe aufzunehmen, wobei sich typischerweise der Messkörper entsprechend dieser Größe verschiebt. Er kann auch seine Lage oder Position relativ zum Schaltungsträger ändern.

Der Messkörper kann vorteilhaft parallel, insbesondere ausschließlich parallel, zum Pfad der Messinduktivitäten beweglich sein. Dies erlaubt beispielsweise eine vorteilhafte und exakte Messung einer eindimensionalen oder zweidimensionalen Größe. Der Messkörper kann jedoch beispielsweise auch quer zum Schaltungsträger beweglich sein.

Bei dem Schaltungsträger kann es sich insbesondere um eine Leiterplatte handeln. Ein solcher Schaltungsträger weist typischerweise eine ebene Oberfläche auf, relativ zu welcher Begriffe wie "parallel" oder "quer" leicht zu erkennen sind.

Bevorzugt ist der Messkörper ferromagnetisch und/oder elektrisch leitfähig. Er kann also beispielsweise ferromagnetisch sein, beispielsweise in Form eines Permanentmagneten. Er kann auch elektrisch leitfähig und nicht ferromagnetisch sein. Außerdem kann er ferromagnetisch und elektrisch leitfähig sein. Es kann sich beispielsweise auch um einen Ferrit handeln, welcher weichmagnetisch, also hochpermeabel, nicht leitfähig, aber auch kein Permanentmagnet ist. Derartige Ausführungen haben sich bewährt, um die Kopplung zwischen Referenzinduktivität und Messinduktivitäten zu beeinflussen.

Der Messkörper kann von den Messinduktivitäten und/oder von der Referenzinduktivität durch einen jeweiligen Luftspalt getrennt sein. Dies ermöglicht eine elektrische Isolierung und eine vorteilhafte freie Beweglichkeit des Messkörpers.

Gemäß einer Ausführung befinden sich die Messinduktivitäten innerhalb der Referenzinduktivität. Dies erlaubt insbesondere eine besonders gute magnetische Kopplung.

Gemäß einer Ausführung umgibt die Referenzinduktivität den Schaltungsträger. Dies erlaubt eine vorteilhafte Kopplung zu Messinduktivitäten, welche sich auf dem Schaltungsträger befinden.

Bevorzugt erzeugt die Referenzinduktivität bei durchfließendem Strom ein Magnetfeld, welches die Messinduktivitäten durchdringt und welches vorzugsweise von dem Messkörper abhängig von der Position des Messkörpers verändert wird. Dies erlaubt ein vorteilhaftes Messverfahren zur Messung einer Messgröße. Dabei ist typischerweise die Position des Messkörpers mit der Messgröße verbunden, so dass sich bei Änderung der Messgröße auch die Position des Messkörpers ändert.

Grundsätzlich kann jedoch beispielsweise auch eine Lage des Messkörpers erfasst werden.

Bevorzugt sind die Messinduktivitäten in SMD-Technik auf dem Schaltungsträger aufgebracht. Dies erlaubt eine einfache, günstige und kompakte Bauform.

In einem nicht zur Erfindung gehörenden Beispiel sind zumindest einige der Messinduktivitäten seriell und/oder parallel elektrisch verschaltet. Durch eine derartige Verschaltung können bestimmte Eigenschaften erreicht werden, wodurch die Schaltung beispielsweise an bestimmte Anwendungen angepasst werden kann. Insbesondere können durch eine parallele oder serielle Verschaltung bestimmte Messinduktivitäten in geeigneter Weise gemeinsam ausgewertet werden. Dabei können beliebige der Messinduktivitäten seriell und/oder parallel verschaltet sein. Gemäß einer Weiterbildung weist der Sensor ferner eine Kapazität auf, welche mit der Referenzinduktivität zu einem Parallelschwingkreis verschaltet ist. Gemäß dieser Weiterbildung weist der Sensor ferner eine elektronische Steuerungseinheit auf. Diese ist direkt mit dem Parallelschwingkreis verbunden, wobei dies sowohl eine unmittelbare Verbindung mittels elektrischer Leitungen oder Leiterbahnen wie auch eine Verbindung über beispielsweise einen Widerstand beinhalten kann.

Die elektronische Steuerungseinheit ist dazu konfiguriert, den Parallelschwingkreis mit einer Anregungsfrequenz oszillierend anzuregen, welche aus einem Takt der elektronischen Steuerungseinheit abgeleitet ist.

Des Weiteren ist die elektronische Steuerungseinheit direkt mit jeder der Messinduktivitäten verbunden und ist dazu konfiguriert, einen Wert, welcher eine Messgröße anzeigt, an der jeweiligen Messinduktivität zu messen.

Die eben beschriebene Ausführung ermöglicht eine vorteilhafte Verwendung einer besonders geeigneten Beschaltung mit elektronischer Steuerungseinheit, wobei eine solche Beschaltung insbesondere eine leichte Auswertung und eine besonders gute Skalierbarkeit ermöglicht. Insbesondere bedarf es zur Verwendung einer Vielzahl von Messinduktivitäten nur eines sehr geringen zusätzlichen Aufwands.

Beim Anzeigen einer Messgröße kann insbesondere auch davon gesprochen werden, dass ein Wert von der Messgröße beeinflusst wird. Beispielsweise kann es sich dabei um eine externe Messgröße wie die Stellung eines Pedals in einem Automobil oder die Stellung eines Reglers handeln.

Gemäß einer Weiterbildung ist die elektronische Steuerungseinheit dazu konfiguriert, Messinduktivitäten zu bestimmen, welche durch einen Messkörper beeinflusst werden, und anschließend eine Position des Messkörpers basierend auf Messungen an diesen Messinduktivitäten zu bestimmen.

Es sei verstanden, dass es sich bei dem Begriff einer Messinduktivität hier um ein Bauelement handelt, welches typischerweise auch als Spule bezeichnet werden kann. Hierauf sei insbesondere in Bezug auf eine eventuelle Verwechslungsgefahr mit dem Begriff der Induktivität als elektrische Eigenschaft einer solchen Spule hingewiesen.

Durch das ebene beschriebene Vorgehen bzw. eine entsprechende Konfiguration der elektronischen Steuerungseinheit können beispielsweise eine, zwei oder drei Messinduktivitäten aus einer Mehrzahl von Messinduktivitäten ermittelt werden, welche zu einem bestimmten Zeitpunkt durch den Messkörper beeinflusst werden. Anschließend können entsprechende Werte an diesen Messinduktivitäten gemessen werden, welche anzeigend sind für die Position des Messkörpers. An anderen Messinduktivitäten, welche im Moment nicht durch den Messkörper beeinflusst werden, kann dann beispielsweise zu diesem Zeitpunkt keine Messung oder keine Weiterverarbeitung durchgeführt werden. Dies kann Aufwand und/oder benötigte Rechenleistung verringern.

Eine eben beschriebene Ausführung ermöglicht insbesondere die vorteilhafte Verwendung eines Messprinzips, welches sich ohne nennenswerten Aufwand nahezu beliebig skalieren lässt. Dies bedeutet insbesondere, dass eine Vielzahl von Messinduktivitäten verwendet werden kann und damit eine sehr hohe Auflösung und/oder ein besonders langer Messbereich erreicht werden kann, ohne dass eine komplizierte Beschaltung nötig ist. Es ist im Wesentlichen lediglich pro verwendeter Messinduktivität ein Eingang der elektronischen Steuerungseinheit sowie eine entsprechende elektrische Anbindung nötig. Die Anregungsfrequenz kann bevorzugt um maximal 25 %, bevorzugt maximal 20 %, besonders bevorzugt maximal 15 %, noch weiter bevorzugt maximal 10 % von einer Resonanzfrequenz des Parallelschwingkreises unterschiedlich sein. Dies hat sich in der Praxis als vorteilhaft erwiesen.

Die Anregungsfrequenz kann insbesondere einstellbar sein, wobei sie insbesondere durch ein Element mit variabler Frequenz gesteuert werden kann.

Vorteilhaft kann zur Messung ein Lock-in-Verstärker verwendet werden.

Die erste Induktivität, die Messinduktivität und/oder die Kapazität können beispielsweise Bauteile mit einer jeweiligen Toleranz zwischen 1 % und 10 %, bevorzugt von 1 % oder von weniger als 1 % sein. Derartige Toleranzen haben sich als vorteilhaft erwiesen.

Die Messinduktivität kann beispielsweise galvanisch oder magnetisch mit der Referenzinduktivität gekoppelt sein.

Gemäß einer Weiterbildung kann der Parallelschwingkreis eine maximale Güte aufweisen, welche durch Maximierung eines Werts von Vt * Vt / V0 erhalten wird. Dabei bezeichnet Vt ein Verhältnis aus Spulenstrom und Zuleitungsstrom bei maximaler Abweichung der Kapazität und der Referenzinduktivität von ihren jeweiligen Werten bei der Resonanzfrequenz des Parallelschwingkreises. V0 bezeichnet ein Verhältnis aus Spulenstrom und Zuleitungsstrom bei jeweiligen Werten von Kapazität und Referenzinduktivität bei der Resonanzfrequenz des Parallelschwingkreises. Ein solches Vorgehen hat sich als besonders vorteilhaft für typische Anwendungen erwiesen.

Die maximale Güte kann insbesondere durch Verschalten eines Widerstands im Parallelschwingkreis begrenzt werden.

Die elektronische Steuerungseinrichtung kann insbesondere dazu ausgebildet sein, einen oder mehrere der folgenden Kennwerte über die Messinduktivitäten zu messen:
- Selbstinduktivität bzw. Induktivität,
- Verlustwiderstand,
- komplexe Impedanz,
- Verlustwinkel,
- Gegeninduktivität zur ersten Induktivität.

Vorteilhaft kann der Sensor zwei, drei oder mehr als drei Messinduktivitäten aufweisen. Beispielsweise kann er auch vier, fünf oder mehr als fünf Messinduktivitäten aufweisen. Insbesondere bei der eben erläuterten Schaltung kann besonders einfach die Anzahl der Messinduktivitäten skaliert werden.

Gemäß einer anderen Weiterbildung weist der Sensor eine Mehrzahl von Messinduktivitäten auf, wobei jede Messinduktivität einen ihr zugeordneten Magnetkern aufweist. Die Messinduktivitäten sind dabei entlang eines Pfads angeordnet. Außerdem sind die Messinduktivitäten elektrisch in Reihe geschaltet. Die Messinduktivitäten weisen jeweilige Induktivitäten auf, welche entlang des Pfads in einer Richtung ansteigen. Bei dem hier als Induktivität bezeichneten Merkmal handelt es sich um die Induktivität als elektrische Eigenschaft einer Spule.

Dies ermöglicht eine gemeinsame Auswertung aller Messinduktivitäten anhand der unterschiedlichen Werte der jeweiligen Induktivität. Auch dies ermöglicht eine einfache Skalierung auf eine Vielzahl von Induktivitäten.

Gemäß einer Ausführung sind die Messinduktivitäten dabei entlang des Pfads in Reihe geschaltet. Dies ermöglicht eine einfache Auswertung. Es sei jedoch verstanden, dass auch andere Verschaltungen möglich sind, welche sich nicht an dem Pfad orientieren.

Insbesondere kann bei einer solchen Ausführung der Messkörper entlang des Pfads bewegbar sein, wodurch eine vorteilhafte Messung dessen Position möglich ist.

Der Sensor ist dabei bevorzugt dazu ausgebildet, ein gemeinsames Ausgangssignal, insbesondere eine Gesamtinduktivität, abhängig von der Position des Messkörpers entlang des Pfads zu erzeugen.

Der Messkörper kann beispielsweise ein ferromagnetischer hochpermeabler Körper, ein elektrisch leitfähiger Körper oder auch ein Permanentmagnet sein. Er kann beispielsweise auch aus Stahl sein, welcher weichmagnetisch, also hochpermeabel, und leitfähig ist.

Die jeweiligen Magnetkerne weisen bevorzugt keine remanente Magnetisierung auf.

Bei dem Schaltungsträger kann es sich insbesondere um eine Leiterplatte, einen Leadframe oder um einen Molded-Interconnected-Devices(MID)-Träger handeln.

Die Messinduktivitäten sind bevorzugt so nah voneinander beabstandet, dass sich bei Bewegung des Messkörpers entlang des Pfads eine Kennlinie der Gesamtinduktivität ergibt, welche zumindest über die Hälfte des Pfads, bevorzugt über zumindest drei Viertel des Pfads oder auch über den ganzen Pfad monoton steigend oder fallend ist. Dies erlaubt eine vorteilhafte Auswertung und vermeidet Zweideutigkeiten.

Der Sensor kann beispielsweise eine Führung aufweisen, welche den Messkörper führt. Eine solche Führung kann den Messkörper insbesondere entlang des erwähnten Pfads führen.

Der Sensor kann ein Betätigungsglied aufweisen, mittels welchem der Messkörper von außen bewegbar ist, beispielsweise entlang des Pfads.

Zahlreiche Messschaltungen, welche aus dem Stand der Technik bekannt sind, weisen das Problem auf, dass eine mehrkanalige, gleichzeitige Messung teuer ist, weil pro Kanal ein hoher Schaltungsaufwand betrieben werden muss. Daher kann es beispielsweise vorteilhaft sein, den allgemeinen Ansatz, in Massen sehr billige SMD-Induktivitäten auf einem Schaltungsträger konventionell zu bestücken und eine Anordnung aus einer Gruppe solcher Induktivitäten als induktives System zu verwenden, mit einer Reihen- oder Parallelschaltung der Induktivitäten zu kombinieren. Dadurch wird eine Gesamtinduktivität gebildet, die mit einem Messkanal preisgünstig gemessen werden kann.

Bei der weiter oben beschriebenen Weiterentwicklung einer Messschaltung besteht insbesondere der Vorteil gegenüber dem Stand der Technik, dass die kanalbezogenen Kosten äußerst gering sind, weil eine Erweiterung einer bestehenden Schaltung um zusätzliche Messkanäle keine zusätzlichen Bauelemente erfordert. Durch eine Zusammenschaltung kann beispielsweise eine Reduktion von Informationen erzielt werden. Aus zwei einzelnen Induktivitäten lassen sich zwei komplexe Parameter gewinnen, aus ihrer Reihen- oder Parallelschaltung typischerweise nur noch einer.

Induktivitäten, welche komplementär auf eine Messgröße reagieren, werden typischerweise nicht zusammengefasst. Während die Einzelelemente messtechnische Informationen liefern, ergibt eine Reihenschaltung typischerweise eine konstante Induktivität, die Parallelschaltung eine nur geringfügige Abhängigkeit von der Messgröße.

Für viele Messaufgaben ist es vorteilhaft, eine Vielzahl von Induktivitäten, insbesondere Messinduktivitäten, zu benutzen, um einen durch das induktive System abzudeckenden Bereich zu belegen. Eine solche Bestückung auf einem Schaltungsträger ist kostengünstig. Vorteilhaft wird der unmittelbare Nahbereich der Induktivitäten für sensorische Funktionen genutzt. Insbesondere durch die oben beschriebene Beschaltung kann in wirtschaftlicher Weise auf Reihen- oder Parallelschaltungen verzichtet werden, wobei trotzdem ein messtechnisch leistungsfähiges System erhalten wird.

Dabei ist es nicht zwingend erforderlich, auf Reihen- oder Parallelschaltungen gänzlich zu verzichten. Beispielsweise können vorteilhaft Reihen- oder Parallelschaltungen von Induktivitäten verwendet werden, die in gleicher Weise auf die Messgröße reagieren, weil dann typische Nachteile nicht auftreten. Typischerweise wird somit eine Anordnung von Einzelinduktivitäten bestimmt, welche die Messaufgabe löst. Danach kann anhand der Kriterien für Informationsreduktion, Parameteränderung als Funktion der Messgröße und Einfluss auf das Signal-Rausch-Verhältnis geprüft werden, welche Induktivitäten schadlos zusammengefasst werden können. Alle Gruppen, auf die das nicht zutrifft, bleiben unzusammengefasst.

Eine Messschaltung benötigt typischerweise für jeden Messkanal einen Teil der Messzeit, die für jeden Messzyklus zur Verfügung steht. Bei vielen sensorischen Anwendungen, zum Beispiel der Regelung von Fahrwerkskomponenten wie Bremse und Lenkung im Automobil, ist der Messzyklus so kurz, dass sich nur eine begrenzte, oft nur knapp ausreichende Anzahl von Einzelmessungen in diesem Zyklus unterbringen lassen. Eine übermäßige Verkürzung der Messung für einen Messkanal hat dabei ebenfalls eine Verringerung des Signal-Rausch-Verhältnisses zur Folge. Daher sollten bevorzugt alle Zusammenfassungen, d.h. Reihen- oder Parallelschaltungen, verwirklicht werden, bei denen die oben geschilderten und/oder bekannten Nachteile nicht oder nur sehr geringfügig auftreten.

Bei vielen Anwendungen ist für Induktivitäten mit besonders großen Kennwerten kein Platz, was insbesondere an einer erwünschten Miniaturisierung von Sensoren liegt. Der daraus folgende, aus messtechnischer Sicht häufig auftretende Mangel an realisierbarer Gesamtinduktivität des induktiven Systems führt typischerweise dazu, dass bei der Zusammenfassung von Induktivitäten die Reihenschaltung in vielen Fällen gegenüber der Parallelschaltung bevorzugt wird, denn die Gesamtinduktivität wird dann größer als die Einzelinduktivitäten.

Weitere Merkmale und Vorteile wird der Fachmann dem nachfolgend mit Bezug auf die beigefügte Zeichnung beschriebenen Ausführungsbeispiel entnehmen. Dabei zeigen:
Fig. 1: eine symbolische Messschaltung, und
Fig. 2: einen Sensor.

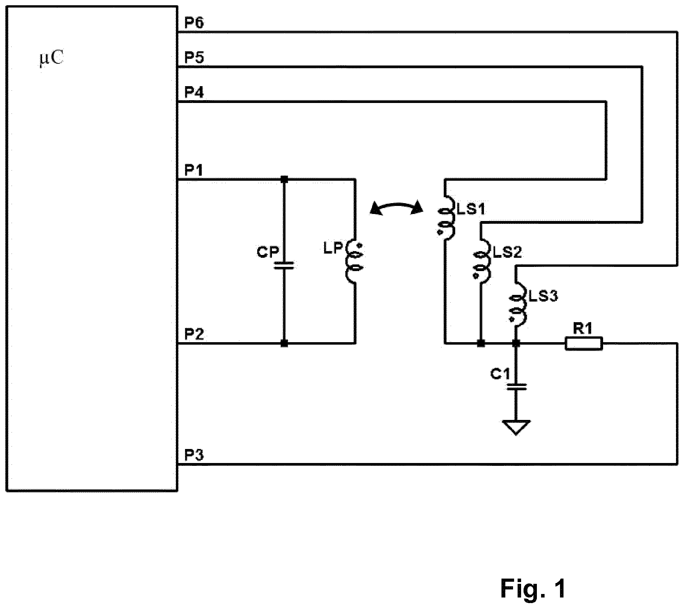

Fig. 1 zeigt ein nicht zur Erfindung gehöriges Beispiel, da die Messinduktivitäten parallel geschaltet sind.

Dabei ist eine elektronische Steuerungseinheit in Form eines Mikrocontrollers µC vorgesehen. Dieser weist insgesamt sechs Ports auf, welche mit P1, P2, P3, P4, P5 und P6 bezeichnet sind.

An den Ports P1 und P2 ist ein Parallelschwingkreis angeschlossen, welcher vorliegend aus einer Referenzinduktivität LP und einem dazu parallel geschalteten Kondensator CP besteht. Am Port P3 ist ein Widerstand R1 angeschlossen, an welchem wiederum ein Glättungskondensator C1 angeschlossen ist. Der Glättungskondensator C1 ist gegenüberliegend mit Masse verbunden.

Auf diese Weise kann an den Pol des Widerstands R1, welcher dem Port P3 gegenüberliegt, eine definierte Spannung eingestellt werden, und zwar insbesondere durch geeignete Pulsweitenmodulation am Port P3. Mit diesem Pol sind drei Messinduktivitäten LS1, LS2, LS3 verbunden, welche mit den Ports P4, P5 und P6 direkt elektrisch verbunden sind. Die Messinduktivitäten LS1, LS2, LS3 sind mit der Referenzinduktivität LP magnetisch gekoppelt. Wenn diese Kopplung durch einen nicht dargestellten Messkörper beeinflusst wird, so können Position und/oder Lage des Messkörpers durch Auswertung von entsprechenden Signalen der Messinduktivitäten LS1, LS2, LS3 ermittelt werden.

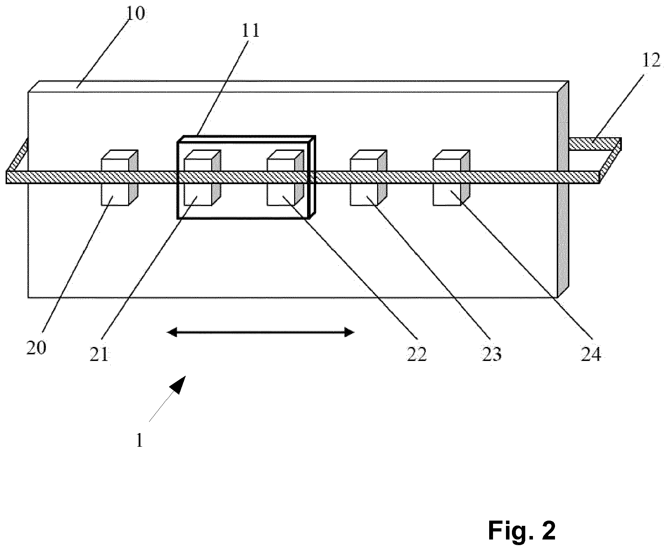

Fig. 2 zeigt einen Sensor 1 gemäß einem Ausführungsbeispiel der Erfindung, welcher vorliegend als linearer Positionssensor ausgeführt ist. Die Messschaltung ist nicht dargestellt, diesbezüglich sei auf Fig. 1 verwiesen.

Bei dem Sensor 1 sind auf einem Schaltungsträger 10 insgesamt fünf Messinduktivitäten 20, 21, 22, 23, 24 in linearer Anordnung aufgebracht. Hierzu wurde eine SMD-Technik verwendet.

Die Messinduktivitäten 20, 21, 22, 23, 24 sind über nicht dargestellte leitfähige Verbindungen auf dem Schaltungsträger 10 mit einer Messschaltung nach Art von Fig. 1 verbunden.

Um den Schaltungsträger 10 herum windet sich in Höhe der Messinduktivitäten 20, 21, 22, 23, 24 eine drahtgewickelte Referenzinduktivität 12, die mit der Messschaltung verbunden ist, jedoch keine direkte leitfähige Verbindung zu den anderen Induktivitäten, also den Messinduktivitäten 20, 21, 22, 23, 24 hat. In der Nähe und auf Höhe der Induktivitäten 20, 21, 22, 23, 24 ist ein ferromagnetischer oder leitfähiger Messkörper 11 angeordnet, der von der gesamten Anordnung aus Messinduktivitäten 12, 20, 21, 22, 23, 24 durch einen jeweiligen Luftspalt getrennt ist. Dies sorgt auch für eine elektrische Isolierung und außerdem für eine freie Beweglichkeit des Messkörpers 11.

Der Messkörper 11 ist beweglich gelagert, so dass er über die lineare Anordnung der Messinduktivitäten 20, 21, 22, 23, 24 verschoben werden kann. Dies ist durch einen Doppelpfeil in Figur 2 gezeigt.

Die Funktionsweise der gezeigten Ausführung besteht darin, dass die Referenzinduktivität 12 ein Magnetfeld erzeugt, welches die Messinduktivitäten 20, 21, 22, 23, 24 durchdringt und in ihnen eine Spannung induziert. Die Messinduktivitäten 20, 21, 22, 23, 24 sind als Induktivitäten Teil der Messschaltung, die dafür von drei auf fünf Messkanäle zu erweitern ist. Die Messschaltung bestimmt die fünf induzierten Spannungen. Diese sind nicht alle gleich, weil das Magnetfeld der Referenzinduktivität 12 durch den Messkörper 11 lokal verändert wird.

Die Messung der induzierten Spannung pro Messinduktivität 20, 21, 22, 23, 24 erlaubt es, die Position des Messkörpers 11 zu berechnen, indem zunächst die ein bis zwei Messinduktivitäten 20, 21, 22, 23, 24, welche unter seinem Einfluss stehen, bestimmt werden und anschließend aus den Signalen dieser Messinduktivitäten ein Positionswert berechnet wird. Dieser kann eine wesentlich höhere Ortsauflösung haben als es dem Rastermaß der Messinduktivitäten 20, 21, 22, 23, 24 entspricht. In dem in Figur 2 gezeigten Zustand befindet sich der Messkörper 11 über den Messinduktivitäten 21 und 22.

Ein Vorteil bei der Auswertung der Signale der Einzelinduktivitäten gegenüber einer Reihenschaltung besteht insbesondere darin, dass die berechnete Ortsauflösung unabhängig von der Anzahl der Induktivitäten ist.

Des Weiteren sei auf den Vorteil verwiesen, dass bei der Verwendung der in Fig. 1 gezeigten Messschaltung und/oder des in Fig. 2 gezeigten Sensors eine besonders günstige und einfache Skalierung auf eine Vielzahl von Messinduktivitäten möglich ist, da letztlich lediglich eine jeweilige zusätzliche Messinduktivität, ein zusätzlicher Port und eine entsprechende Verbindung nötig sind.

## Patentansprüche

1. Sensor (1), aufweisend
- einen Schaltungsträger (10),
- eine Anzahl von Messinduktivitäten (20, 21, 22, 23, 24), welche auf dem Schaltungsträger (10) aufgebracht sind, und
- eine Referenzinduktivität (12), welche mit den Messinduktivitäten (20, 21, 22, 23, 24) gekoppelt ist, **gekennzeichnet durch**
- eine Kapazität (CP), welche mit der Referenzinduktivität (12) zu einem Parallelschwingkreis verschaltet ist, und
- eine elektronische Steuerungseinheit (mC), wobei die elektronische Steuerungseinheit (mC) direkt mit dem Parallelschwingkreis verbunden ist und dazu konfiguriert ist, den Parallelschwingkreis mit einer Anregungsfrequenz oszillierend anzuregen, welche aus einem Takt der elektronischen Steuerungseinheit abgeleitet ist, und wobei die elektronische Steuerungseinheit (mC) direkt mit jeder der Messinduktivitäten (20, 21, 22, 23, 24) verbunden ist und dazu konfiguriert ist, einen Wert, welcher eine Messgröße anzeigt, an der jeweiligen Messinduktivität (20, 21, 22, 23, 24) zu messen,
- wobei die elektronische Steuerungseinheit (mC) dazu konfiguriert ist,
- Messinduktivitäten (20, 21, 22, 23, 24) zu bestimmen, welche durch einen Messkörper (11) beeinflusst werden, und anschließend
- eine Position des Messkörpers (11) basierend auf Messungen an diesen Messinduktivitäten (20, 21, 22, 23, 24) zu bestimmen,
- wobei der Sensor (1) eine Mehrzahl von Messinduktivitäten (20, 21, 22, 23, 24) aufweist,
- wobei jede Messinduktivität einen ihr zugeordneten Magnetkern aufweist,
- wobei die Messinduktivitäten (20, 21, 22, 23, 24) entlang eines Pfads angeordnet sind,
- wobei die Messinduktivitäten (20, 21, 22, 23, 24) elektrisch in Reihe geschaltet sind, und
- wobei die Messinduktivitäten (20, 21, 22, 23, 24) jeweilige Induktivitäten aufweisen, welche entlang des Pfads in einer Richtung ansteigen.

2. Sensor (1) nach Anspruch 1,
- wobei die Messinduktivitäten (20, 21, 22, 23, 24) von der Referenzinduktivität (12) elektrisch isoliert sind.

3. Sensor (1) nach einem der vorhergehenden Ansprüche,
- welcher als linearer Positionssensor ausgebildet ist.

4. Sensor (1) nach einem der vorhergehenden Ansprüche,
- wobei die Messinduktivitäten (20, 21, 22, 23, 24) entlang eines Pfads, insbesondere eines geraden Pfads oder eines Bogens oder Kreisbogens, auf dem Schaltungsträger (10) aufgebracht sind.

5. Sensor (1) nach einem der vorhergehenden Ansprüche,
- welcher ferner einen Messkörper (11) aufweist, welcher relativ zum Schaltungsträger (10) beweglich ist.

6. Sensor (1) nach Anspruch 4 und Anspruch 5,
- wobei der Messkörper (11) parallel, insbesondere ausschließlich parallel zum Pfad der Messinduktivitäten (20, 21, 22, 23, 24) beweglich ist.

7. Sensor (1) nach einem der Ansprüche 5 oder 6,
- wobei der Messkörper (11) ferromagnetisch ist und/oder elektrisch leitfähig ist.

8. Sensor (1) nach einem der Ansprüche 5 bis 7,
- wobei der Messkörper (11) von den Messinduktivitäten (20, 21, 22, 23, 24) und/oder von der Referenzinduktivität (12) durch einen jeweiligen Luftspalt getrennt ist.

9. Sensor (1) nach einem der vorhergehenden Ansprüche,
- wobei sich die Messinduktivitäten (20, 21, 22, 23, 24) innerhalb der Referenzinduktivität (12) befinden und/oder wobei die Referenzinduktivität (12) den Schaltungsträger (10) umgibt.

10. Sensor (1) nach einem der vorhergehenden Ansprüche,
- wobei die Referenzinduktivität (12) bei durchfließendem Strom ein Magnetfeld erzeugt, welches die Messinduktivitäten (20, 21, 22, 23, 24) durchdringt und welches vorzugsweise von dem Messkörper (11) abhängig von der Position des Messkörpers (11) verändert wird.

11. Sensor (1) nach einem der vorhergehenden Ansprüche,
- wobei die Messinduktivitäten (20, 21, 22, 23, 24) in SMD-Technik auf dem Schaltungsträger (10) aufgebracht sind.

## Claims

1. Sensor (1) having
- a circuit carrier (10),
- a number of measurement inductances (20, 21, 22, 23, 24) which are applied to the circuit carrier (10), and
- a reference inductance (12) which is coupled to the measurement inductances (20, 21, 22, 23, 24), **characterized by**
- a capacitance (CP) which is interconnected with the reference inductance (12) to form a parallel resonant circuit, and
- an electronic control unit (mC),
wherein the electronic control unit (mC) is connected directly to the parallel resonant circuit and is configured to excite the parallel resonant circuit into oscillation at an excitation frequency that is derived from a clock of the electronic control unit, and
wherein the electronic control unit (mC) is connected directly to each of the measurement inductances (20, 21, 22, 23, 24) and is configured to measure a value, which indicates a measurement variable, at the respective measurement inductance (20, 21, 22, 23, 24),
- wherein the electronic control unit (mC) is configured
- to determine measurement inductances (20, 21, 22, 23, 24) which are influenced by a measurement body (11), and subsequently
- to determine a position of the measurement body (11) based on measurements at said measurement inductances (20, 21, 22, 23, 24),
- wherein the sensor (1) has a plurality of measurement inductances (20, 21, 22, 23, 24),
- wherein each measurement inductance has a magnet core associated therewith,
- wherein the measurement inductances (20, 21, 22, 23, 24) are arranged along a path,
- wherein the measurement inductances (20, 21, 22, 23, 24) are electrically connected in series, and
- wherein the measurement inductances (20, 21, 22, 23, 24) have respective inductances which increase along the path in one direction.

2. Sensor (1) according to Claim 1,
- wherein the measurement inductances (20, 21, 22, 23, 24) are electrically insulated from the reference inductance (12).

3. Sensor (1) according to one of the preceding claims,
- which is configured as a linear position sensor.

4. Sensor (1) according to one of the preceding claims,
- wherein the measurement inductances (20, 21, 22, 23, 24) are applied to the circuit carrier (10) along a path, in particular a straight path or an arc or circular arc.

5. Sensor (1) according to one of the preceding claims,
- which also has a measurement body (11) which can be moved relative to the circuit carrier (10).

6. Sensor (1) according to Claim 4 and Claim 5,
- wherein the measurement body (11) can be moved parallel, in particular exclusively parallel, to the path of the measurement inductances (20, 21, 22, 23, 24) .

7. Sensor (1) according to either of Claims 5 and 6,
- wherein the measurement body (11) is ferromagnetic and/or electrically conductive.

8. Sensor (1) according to one of Claims 5 to 7,
- wherein the measurement body (11) is separated from the measurement inductances (20, 21, 22, 23, 24) and/or from the reference inductance (12) by a respective air gap.

9. Sensor (1) according to one of the preceding claims,
- wherein the measurement inductances (20, 21, 22, 23, 24) are located within the reference inductance (12) and/or wherein the reference inductance (12) surrounds the circuit carrier (10).

10. Sensor (1) according to one of the preceding claims,
- wherein the reference inductance (12) generates a magnetic field when current flows through, said magnetic field penetrating the measurement inductances (20, 21, 22, 23, 24) and preferably being changed by the measurement body (11) depending on the position of the measurement body (11).

11. Sensor (1) according to one of the preceding claims,
- wherein the measurement inductances (20, 21, 22, 23, 24) are applied to the circuit carrier (10) using SMD technology.

## Revendications

1. Capteur (1), comprenant
- un porte-circuit (10),
- un certain nombre d'inductances de mesure (20, 21, 22, 23, 24) qui sont montées sur le porte-circuit (10) et
- une inductance de référence (12) qui est couplée aux inductances de mesure (20, 21, 22, 23, 24), **caractérisé par**
- un condensateur (CP), qui est interconnecté avec l'inductance de référence (12) en un circuit oscillant parallèle, et
- une unité de commande électronique (mC), l'unité de commande électronique (mC) étant reliée directement au circuit oscillant parallèle et étant configurée pour exciter le circuit oscillant parallèle en oscillation avec une fréquence d'excitation, laquelle est dérivée d'une horloge de l'unité de commande électronique, et l'unité de commande électronique (mC) étant reliée directement à chacune des inductances de mesure (20, 21, 22, 23, 24) et étant configurée pour mesurer, au niveau de l'inductance de mesure (20, 21, 22, 23, 24) respective, une valeur qui indique une grandeur mesurée,
- l'unité de commande électronique (mC) étant configurée pour
- déterminer les inductances de mesure (20, 21, 22, 23, 24) qui sont influencées par un corps de mesure (11), et ensuite
- déterminer une position du corps de mesure (11) en se basant sur les mesures au niveau de ces inductances de mesure (20, 21, 22, 23, 24),
- le capteur (1) possédant une pluralité d'inductances de mesure (20, 21, 22, 23, 24),
- chaque inductance de mesure possédant un noyau magnétique qui lui est associé,
- les inductances de mesure (20, 21, 22, 23, 24) étant disposées le long d'un chemin,
- les inductances de mesure (20, 21, 22, 23, 24) étant branchées électriquement en série, et
- les inductances de mesure (20, 21, 22, 23, 24) présentant respectivement des inductances qui croissent dans une direction le long du chemin.

2. Capteur (1) selon la revendication 1,
- les inductances de mesure (20, 21, 22, 23, 24) étant isolées électriquement de l'inductance de référence (12).

3. Capteur (1) selon l'une des revendications précédentes,
- lequel est réalisé sous la forme d'un capteur de position linéaire.

4. Capteur (1) selon l'une des revendications précédentes,
- les inductances de mesure (20, 21, 22, 23, 24) étant montées sur le porte-circuit (10) le long d'un chemin, notamment d'un chemin droit ou d'un coude ou d'un arc de cercle.

5. Capteur (1) selon l'une des revendications précédentes,
- lequel possède en outre un corps de mesure (11) qui est mobile par rapport au porte-circuit (10).

6. Capteur (1) selon la revendication 4 et la revendication 5,
- le corps de mesure (11) étant mobile parallèlement, notamment exclusivement parallèlement au chemin des inductances de mesure (20, 21, 22, 23, 24).

7. Capteur (1) selon l'une des revendications 5 et 6,
- le corps de mesure (11) étant ferromagnétique et/ou étant électriquement conducteur.

8. Capteur (1) selon l'une des revendications 5 à 7,
- le corps de mesure (11) étant séparé des inductances de mesure (20, 21, 22, 23, 24) et/ou de l'inductance de référence (12) par un entrefer respectif.

9. Capteur (1) selon l'une des revendications précédentes,
- les inductances de mesure (20, 21, 22, 23, 24) se trouvant à l'intérieur de l'inductance de référence (12) et/ou l'inductance de référence (12) entourant le porte-circuit (10).

10. Capteur (1) selon l'une des revendications précédentes,
- l'inductance de référence (12), lorsqu'un courant circule à travers celle-ci, générant un champ magnétique qui traverse les inductances de mesure (20, 21, 22, 23, 24) et qui est de préférence modifié par le corps de mesure (11) en fonction de la position du corps de mesure (11) .

11. Capteur (1) selon l'une des revendications précédentes,
- les inductances de mesure (20, 21, 22, 23, 24) étant montées sur le porte-circuit (10) en technologie CMS.
